(19) Europäisches Patentamt
European Patent Office
Office européen des brevets

(11) EP 0 323 427 B2

(12) NOUVEAU FASCICULE DE BREVET EUROPEEN

(45) Date de publication et mention de la décision concernant l'opposition:
**03.03.1999 Bulletin 1999/09**

(45) Mention de la délivrance du brevet:
**01.09.1993 Bulletin 1993/35**

(21) Numéro de dépôt: **88870188.5**

(22) Date de dépôt: **15.12.1988**

(51) Int Cl.[6]: **G03F 7/022**

# (54) Compositions photosensibles contenant des résines phénoliques et des dérivés de diazoquinone

Lichtempfindliche Zusammensetzungen mit Phenolkunststoffen und Quinondiariden

Light-sensitive compositions with phenol resins and quinone diarides

(84) Etats contractants désignés:
**AT BE CH DE ES FR GB GR IT LI LU NL SE**

(30) Priorité: **18.12.1987 GB 8729510**

(43) Date de publication de la demande:
**05.07.1989 Bulletin 1989/27**

(73) Titulaire: **UCB, S.A.**
**1070 Bruxelles (BE)**

(72) Inventeurs:
- **Roland, Bruno**
  **B-3030 Heverlee (BE)**
- **Vandendriesche, Jan**
  **B-3044 Haasrode (BE)**
- **Jakus, Catherine**
  **B-1920 Diegem (BE)**

(74) Mandataire: **Dusseldorp, Raymond et al**
**UCB S.A.**
**Département D.T.B.**
**33, rue d'Anderlecht**
**1620 Drogenbos (BE)**

(56) Documents cités:

| | |
|---|---|
| EP-A- 0 184 567 | DE-A- 1 447 015 |
| DE-A- 1 597 786 | DE-A- 2 139 981 |
| FR-A- 2 075 039 | FR-A- 2 234 584 |
| US-A- 3 745 011 | US-A- 4 307 173 |

- **IBM TECHNICAL DISCLOSURE BULLETIN, vol. 20, no. 5 octobre 1977, New York, US; H. HIRAOKA et al.: "Electron-beam and X-ray resists"**
- **PATENT ABSTRACTS OF JAPAN, vol. 11, no. 79 (P-555)[2526], 11 mars 1987, page 26 P 555; & JP-A-61 235 832 (KONISHIROKU PHOTO IND. CO. LTD) 21-10-1986**
- **PATENT ABSTRACTS OF JAPAN, vol. 8, no. 282 (P-323)[1719], 22 décembre 1984, page 123 P 323; & JP-A-59 148 060 (TORAY K.K.) 24-08-1984**

EP 0 323 427 B2

## Description

La présente invention se rapporte à des compositions photosensibles utilisables comme photorésists dans la fabrication de circuits semi-conducteurs à très grande intégration, de même qu'à un procédé de formation de motifs dans lequel on fait usage de ces compositions. Plus particulièrement, la présente invention concerne des compositions photosensibles contenant des résines phénoliques et des dérivés de diazoquinone qui présentent un meilleur contraste et une meilleure sélectivité par l'addition de faibles quantités d'un acide sulfonique ou carboxylique aromatique polycyclique condensé et/ou d'un de ses sels d'ammonium.

Le procédé dont on se sert dans la production industrielle de circuits intégrés pour obtenir des motifs spécifiques est appelé "microlithographie". Dans ce procédé, la composition photosensible (ou photorésist) est d'abord déposée sur un substrat, par exemple une tranche de silicium, puis exposée selon l'image à un rayonnement ultraviolet et développée. Après le développement, les parties restantes de la couche de photorésist agissent alors comme une barrière protectrice au cours des étapes ultérieures comme la gravure, l'implantation d'ions, etc... D'habitude, le développement est effectué dans un liquide en mettant à profit le changement de solubilité de la couche de photorésist induit par le rayonnement. Toutefois, un procédé préféré de développement est la gravure sèche en utilisant par exemple un plasma d'oxygène, vu que ce procédé évite l'utilisation de grandes quantités de solvant pour le développement et permet le contrôle dimensionnel souhaité pour la création de motifs dont les dimensions sont de l'ordre du micromètre ou même inférieures. Cependant, lorsqu'on utilise la gravure sèche pour créer les motifs, il est de la plus haute importance qu'une différenciation suffisante soit réalisée entre les parties exposées et non exposées des photorésists. Ceci peut être réalisé, par exemple, en rendant certaines parties de la matière organique du photorésist plus résistantes à la gravure au plasma.

Une méthode très efficace pour obtenir une réduction de la vitesse de gravure consiste à incorporer des matières inorganiques dans la couche organique du résist. Au cours des étapes de développement, les éléments inorganiques seront oxydés par le plasma d'oxygène en oxydes non-volatils, qui formeront une barrière protectrice envers le plasma. L'incorporation d'une quantité suffisante d'éléments inorganiques produira une réduction spectaculaire de la vitesse de gravure dans le plasma d'oxygène.

Très récemment, on a développé des procédés permettant l'incorporation, selon l'image, d'éléments inorganiques tels que le silicium, dans la couche organique du résist et qui, par conséquent, permettent la gravure sèche en utilisant un plasma d'oxygène. Un exemple d'un tel procédé est décrit dans la demande de brevet européen 184.567. Dans ce procédé, on utilise des compositions photosensibles comprenant une résine phénolique et un dérivé photosensible de diazoquinone. Cette composition photosensible est successivement déposée sur un substrat, par exemple une tranche de silicium, exposée selon l'image à de la lumière ultraviolette d'une longueur d'onde comprise entre 100 et 600 nm, traitée par un agent de silylation comme l'hexaméthyldisilazane et développée par voie sèche en utilisant une technique de gravure au plasma d'oxygène ou par ions réactifs d'oxygène. L'exposition de la composition photosensible au rayonnement ultraviolet produit une perméabilité accrue des parties exposées, ce qui permet à l'agent de silylation de diffuser sélectivement dans ces parties exposées. Par conséquent, pendant le traitement ultérieur du photorésist par l'agent de silylation, ce dernier va pénétrer sélectivement dans ces parties exposées où il va réagir avec les groupes hydroxyles libres de la résine phénolique.

Au cours de l'étape de développement par voie sèche, la couche supérieure des parties silylées de la surface du résist est transformée dans un plasma d'oxygène anisotrope en une couche de $SiO_2$ réfractaire qui protège les couches sous-jacentes d'une oxydation ultérieure. Il en résulte que seules les parties exposées, contenant du silicium, vont subsister, produisant ainsi un motif négatif.

Dans ce procédé, la silylation est effectuée en traitant la surface du résist, après exposition au rayonnement UV, avec un agent de silylation, qui peut être vaporisé, liquéfié ou dissous dans un solvant. Des agents de silylation appropriés sont l'hexaméthyldisilazane, l'heptaméthyldisilazane, l'hexaphényldisilazane, le tétrachlorosilane, les alkyl- et arylhalosilanes, la N-triméthylsilyldiméthylamine, la N-triméthylsilyldiéthylamine, le 1,3-bis(chlorométhyl)-1,1,3,3-tétraméthyldisilazane, le N-triméthylsilylimidazole, la N-triméthylsilylacétamide, l'hexaméthylsilanediamine, la N,O-bis (triéthylsilyl)acétimide, la N,N'-bis(triméthylsilyl)-urée, la N,N'-diphényl-N-(triméthylsilyl)urée et les mélanges d'au moins deux de ces composés.

Ce procédé présente plusieurs avantages importants. Comme l'incorporation du silicium peut avantageusement être limitée à la partie supérieure relativement mince du résist, il n'est pas nécessaire que le rayonnement utilisé pour l'exposition pénètre à travers toute l'épaisseur de la couche de résist. L'exposition de la partie supérieure relativement mince du résist est donc suffisante, à la différence des systèmes de résist développés par voie humide où l'exposition à travers toute l'épaisseur est indispensable pour obtenir un développement complet.

De plus, il est bien connu qu'une plus grande résolution peut être obtenue par l'usage d'un rayonnement de faible longueur d'onde, comme le rayonnement ultraviolet en dessous de 320 nm. Toutefois, les résines phénoliques absorbent fortement dans cette région du spectre ultraviolet. Dans les techniques de développement par voie humide, cela présente un désavantage important si l'exposition est effectuée à des longueurs d'onde inférieures à 300 nm,

comme l'exposition aux UV lointains à 249 et 193 nm. Par contre, dans le procédé décrit dans la demande de brevet européen mentionnée ci-dessus, ceci constitue un avantage important vu que la lumière ne pénètre pas suffisamment profondément pour être réfléchie par le substrat. D'autre part, lorsqu'on utilise de l'UV proche (350-500 nm) pour l'exposition, l'absorption de la résine elle-même peut ne pas être suffisante pour éviter les réflexions de la lumière par le substrat. Dans ce cas, dans le procédé mentionné ci-dessus de la demande de brevet européen 184.567, la couche de résist peut facilement être rendue très absorbante pour éviter les réflexions de la lumière par le substrat étant donné que la formation des images doit se produire seulement dans une couche relativement mince à la partie supérieure du résist (contrairement aux systèmes de résist à développement par voie humide). L'absorption de la lumière de la composition photosensible peut être augmentée par exemple par l'addition de colorants spécifiques qui absorbent la lumière à une longueur d'onde comprise entre 350 et 450 nm.

Dans la fabrication de circuits à très grande intégration, il est capital que la composition photosensible présente un grand contraste et une grande sélectivité parce que cela conduit à une qualité supérieure de l'image et à des capacités de résolution supérieures.

On peut trouver la définition du contraste dans l'ouvrage de L.P. THOMPSON, C.G. WILLSON et M.J. BOWDEN, "Introduction to Microlithography", American Chemical Society Symposium Series 219, Amer.Chem.Soc., Washington D.C., 1983, Chapitre 4,p.168-169. Le contraste est déterminé expérimentalement en exposant une couche de résist à des doses d'exposition variables et en mesurant l'épaisseur résiduelle du film après développement. Lorsqu'on porte en graphique l'épaisseur résiduelle du film après développement en fonction du logarithme de la dose d'exposition aux UV, on obtient une courbe de contraste. Jusqu'à une certaine dose d'exposition limite Do, il ne subsistera pas de résist après le développement; à des doses d'exposition supérieures à Do, l'épaisseur résiduelle du film restant après développement augmentera de manière linéaire avec le logarithme de la dose d'exposition et restera finalement au même niveau à une certaine épaisseur résiduelle du film $t_x$ Le contraste (gamma) est déterminé par la pente de la partie linéaire de cette courbe de contraste et peut être exprimé par l'équation suivante:

$$\text{gamma} = \frac{1}{(\log Dm - \log Do)}$$

dans laquelle Dm est la dose d'exposition déterminée par extrapolation de la partie linéaire de la courbe de contraste à la valeur correspondant à l'épaisseur résiduelle du film $t_x$ restant après développement

et Do est la dose d'exposition limite comme expliqué cidessus.

Il est facile de comprendre que plus la pente de la courbe de contraste est raide, plus le contraste sera élevé. Par ailleurs, un contraste plus élevé donnera un bien meilleur profil avec des parois latérales plus verticales vu que l'influence de la diffraction de la lumière aux bords des motifs de résist sera considérablement moindre (Dm étant plus proche de Do). Le contraste des compositions photosensibles à base de résines phénoliques et de diazoquinones développées par voie humide est généralement inférieur à 2,5. Par conséquent, le développement de compositions photosensibles qui possèdent un contraste élevé est hautement souhaitable.

La sélectivité (s) est le rapport de la vitesse de gravure (ou de la vitesse développement) dans la zone non exposée par rapport à la vitesse de gravure dans la zone exposée et peut être exprimée par la formule suivante:

$$s = t_i/(t_i - t_x)$$

dans laquelle $t_i$ représente l'épaisseur initiale du film

$t_x$ représente l'épaisseur résiduelle du film restant après le développement du résist exposé.

Il est clair que l'épaisseur résiduelle du film après développement est directement liée à la sélectivité.

Des valeurs de sélectivité supérieures à 10 sont considérées comme bonnes.

Le contraste et la sélectivité peuvent non seulement affecter les capacités de résolution et les profils, mais aussi le contrôle de la largeur des lignes. On peut s'attendre à ce que plus le contraste et la sélectivité sont élevés, moindre est la perte de largeur des lignes durant le développement. Ceci est particulièrement important dans un procédé tel que celui décrit dans la demande de brevet européen mentionnée précédemment où le développement est réalisé par gravure sèche dans un plasma d'oxygène. En effet, dans ce procédé, la quantité de silicium qui est incorporée dans le résist et, par conséquent, le degré de résistance à la gravure dépendra de la dose d'exposition (si tous les autres facteurs sont maintenus constants). Du fait de la diffraction de la lumière, la dose d'exposition se situe entre Do et Dm dans les zones proches des bords des motifs de résist désirés. Ceci signifie que dans ces zones, la vitesse de gravure pendant le développement au plasma diminuera graduellement d'un minimum au-dessus de la dose d'exposition Dm à un maximum en dessous de la dose d'exposition Do, produisant ainsi des motifs négatifs avec des parois latérales inclinées après le développement. Il en résulte qu'à des vitesses de gravure intermédiaires (entre les vitesses de gravure maximum et minimum), il se produira également une diminution de la largeur des lignes en fonction

du temps de développement, par exemple lorsqu'une surgravure est appliquée. En résumé, on peut affirmer que plus la différence entre les vitesses de gravure maximum et minimum est faible, c'est-à-dire plus le contraste est élevé (Dm étant plus proche de Do) et plus la sélectivité est élevée, plus petite sera la perte de largeur des lignes (et meilleur sera le contrôle de la largeur des lignes).

Il subsiste donc un besoin d'une composition photosensible qui ait une valeur de contraste et une sélectivité aussi élevées que possible.

Dès lors, un objet de la présente invention est de procurer des compositions photosensibles qui possèdent une valeur de contraste élevée et une sélectivité élevée et plus particulièrement des compositions photosensibles qui présentent un contraste et une sélectivité élevés lorsqu'elles sont utilisées dans des procédés comme ceux décrits dans la demande de brevet européen 184.567, où une résolution élevée est obtenue par incorporation sélective d'un composé de silicium dans les parties irradiées du photorésist et développement ultérieur par des techniques de gravure sèche.

Suite à des travaux de recherche, il a été trouvé maintenant que cet objectif peut être atteint en ajoutant une faible quantité d'un acide sulfonique ou carboxylique aromatique polycyclique condensé et/ou d'un de ses sels d'ammonium, à une composition photosensible contenant des résines phénoliques et des dérivés de diazoquinone sous la forme d'un ester partiel d'un acide diazoquinone -sulfonique ou carboxylique et de la résine phénolique.

En effet, on a constaté avec surprise que l'addition d'une faible quantité d'un acide sulfonique ou -carboxylique aromatique polycyclique condensé et/ou d'un de ses sels d'ammonium, à une composition photosensible à base de résines phénoliques et de diazoquinones sous la forme d'un ester partiel d'un acide diazoquinone -sulfonique ou -carboxylique et de la résine phénolique, augmente considérablement le contraste (jusqu'à une valeur aussi élevée que 11) de même que la sélectivité d'une telle composition et plus particulièrement lorsqu'une telle composition est utilisée dans un procédé tel que décrit dans la demande de brevet européen 184.567 mentionnée plus haut. De plus, dans ce dernier cas, c'est-à-dire lorsqu'elle est utilisée dans un procédé tel que décrit dans la demande de brevet européen, on a constaté qu'une composition à base de résines phénoliques et de diazoquinones sous la forme d'un ester partiel d'un acide diazoquinone -sulfonique ou -carboxylique et de la résine phénolique, à laquelle un acide et/ou un de ses sels d'ammonium mentionnés plus haut sont ajoutés, permet, en plus d'une augmentation du contraste et de la sélectivité, une diminution substantielle de la température de silylation par comparaison avec une composition à laquelle cet acide ou un de ses sels d'ammonium n'est pas ajouté. A cet égard, il y a lieu de remarquer que dans un tel procédé, une diminution de la température de silylation présente un avantage important parce que les risques d'explosion causés par la décomposition de l'agent de silylation peuvent être diminués; en effet, cette décomposition peut déjà se produire à une température inférieure à 200°C selon la structure de l'agent de silylation et les conditions de silylation.

Dès lors, la présente invention procure une composition photosensible améliorée comprenant au moins une résine phénolique, au moins un dérivé de diazoquinone sous la forme d'un ester partiel d'un acide diazoquinone -sulfonique ou -carboxylique et de la résine phénolique et au moins un acide sulfonique ou carboxylique aromatique polycyclique condensé, sous la forme de l'acide libre et/ou d'un sel d'ammonium, le cation du sel d'ammonium ayant la formule

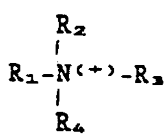

dans laquelle $R_1$, $R_2$, $R_3$ et $R_4$, qui peuvent être identiques ou différents, représentent chacun un atome d'hydrogène ou un groupe alkyle ou hydroxyalkyle contenant de 1 à 4 atomes de carbone, avec la restriction que l'acide sulfonique ou carboxylique aromatique est autre qu'un acide aminé aromatique et que l'acide coumarilique.

Les acides sulfoniques ou carboxyliques aromatiques polycycliques condensés utilisés dans les compositions photosensibles selon la présente invention comme additifs pour augmenter le contraste et la sélectivité, peuvent être utilisés sous la forme de l'acide libre et/ou d'un sel d'ammonium.

Les acides sulfoniques ou carboxyliques aromatiques polycycliques condensés préférés sont les acides naphtalènesulfoniques ou -carboxyliques, ou les acides diazoquinone-sulfoniques ou -carboxyliques, comme par exemple

l'acide 1-naphtalènesulfonique,
l'acide 2-naphtalènesulfonique,
l'acide 3-diazo-3,4-dihydro-4-oxo-1-naphtalènesulfonique,
l'acide 6-diazo-5,6-dihydro-5-oxo-1-naphtalènesulfonique,
l'acide 6-diazo-5,6-dihydro-5-oxo-2-naphtalènesulfonique,

l'acide 4-diazo-3,4-dihydro-3-oxo-1-naphtalènesulfonique,
l'acide 5-diazo-5,6-dihydro-6-oxo-1-naphtalènesulfonique,
l'acide 5-diazo-5,6-dihydro-6-oxo-2-naphtalènesulfonique,

les acides carboxyliques correspondants et les mélanges d'au moins deux de ces composés.

Les acides sulfoniques aromatiques polycycliques condensés particulièrement préférés qui peuvent être utilisés dans les compositions photosensibles conformément à la présente invention sont les acides diazoquinone-sulfoniques représentés par la formule suivante:

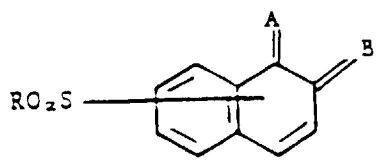

dans laquelle A représente $N_2$ ou O et B est O lorsque A est $N_2$ ou B est $N_2$ lorsque A est O et R représente OH, ou 0M, où M est un ion ammonium ou ammonium substitué.

Il est bien connu que les acides diazoquinone-sulfoniques ou carboxyliques mentionnés ci-dessus, sous la forme d'acide libre, sont en équilibre avec les sels de diazonium internes correspondants. Cet équilibre dépend du pH et aussi de la concentration, puisqu'une molécule d'acide peut servir de contre-ion au sel de diazonium d'une autre molécule d'acide.

L'utilisation des acides diazoquinone-sulfoniques ou -carboxyliques sous la forme de ces sels de diazonium fait également partie de la présente invention.

Lorsque les acides sulfoniques ou carboxyliques aromatiques polycycliques condensés mentionnés ci-dessus sont sous la forme d'un sel d'ammonium, le cation du sel d'ammonium est de préférence choisi parmi ceux qui répondent à la formule

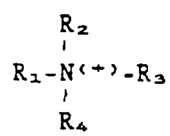

dans laquelle $R_1$, $R_2$, $R_3$ et $R_4$, qui peuvent être identiques ou différents, représentent chacun un atome d'hydrogène ou un groupe alkyle ou hydroxyalkyle contenant de 1 à 4 atomes de carbone. Des exemples de tels composés sont les sels d'ammonium, de monométhylammonium, de diméthylammonium et de triméthylammonium de l'acide 2-naphtalènesulfonique, de l'acide 3-diazo-3,4-dihydro-4-oxo-1-naphtalène-sulfonique ou de l'acide 6-diazo-5,6-dihydro-5-oxo-1-naphtalènesulfonique, etc.

Etant donné la grande diversité de résines phénoliques et de dérivés de diazoquinone photosensibles possible, la quantité d'acide appropriée nécessaire pour obtenir une augmentation substantielle du contraste et de la sélectivité doit être déterminée par quelques essais préliminaires. Cependant, en règle générale, une quantité d'acide d'environ 0,01 à environ 24% en poids, calculée par rapport au poids total de la composition photosensible, donnera un contraste et une sélectivité plus élevée. Une quantité préférée d'acide est comprise entre 0.05 et 10% en poids et est plus particulièrement de 0,2 à 2% en poids, calculée par rapport au poids total de la composition photosensible. Comme illustré dans les exemples donnés ci-après, des valeurs de contraste élevées, par exemple supérieures à 10, associées à d'excellentes valeurs de sélectivité de l'ordre de 22-23 peuvent déjà être obtenues en utilisant une quantité d'acide de 0,5% en poids calculée par rapport au poids total de la composition photosensible.

Les résines phénoliques qui peuvent être utilisées dans les compositions photosensibles de la présente invention sont les poly(vinylphénols), les novolaques préparées par condensation de phénol, d'un mono-, di- ou trialkylphénol (par exemple, l'o-crésol, le m-crésol, le p-crésol, les xylénols, le p-tert.-butylphénol, etc...), d'un arylphénol, d'un naphtol non substitué, de naphtols substitués, de résorcinols, de résorcinols alkyl-substitués, de pyrogallols, de pyrogallols alkyl-substitués ou de leurs mélanges, avec du formaldéhyde, de l'acétaldéhyde, du benzaldéhyde ou leurs mélanges, ou encore les mélanges de deux ou plusieurs des résines précitées. Selon une forme de réalisation préférée, la résine phénolique est une novolaque co-condensée obtenue par condensation de formaldéhyde avec un mélange de phénol et de p-tert.-butylphénol dont le rapport molaire entre le p-tert.-butylphénol et le phénol est compris entre 1:10 et 10:1.

Les dérivés de diazoquinone photosensibles sous la forme d'un ester partiel d'un acide diazoquinone-sulfonique ou -carboxylique et de la résine phénolique qui peuvent être utilisés dans les compositions photosensibles de la présente invention sont bien connus de l'homme de métier et peuvent comprendre divers composés qui possèdent un ou plusieurs groupements diazoquinone tels que ceux qui sont décrits en détail dans "Light-Sensitive Systems", de J. KOSAR, John Wiley & Sons, Inc., New-York, 1965, Chapitre 7.4, p.339-352. Les dérivés de diazoquinone qui conviennent particulièrement bien pour la présente invention comprennent les esters partiels d'halogénures des acides diazoquinone-sulfoniques ou - carboxyliques mentionnés ci-dessus et de résines phénoliques comme celles décrites précédemment. A titre d'exemple, on peut citer l'ester partiel du chlorure de 6-diazo-5,6-dihydro-5-oxo-1-naphtalène-sulfonyle avec une résine phénolique.

Les compositions photosensibles selon la présente invention contiennent une quantité d'environ 30 à environ 95% en poids de résine phénolique et d'environ 4 à environ 60% en poids de dérivé de diazoquinone calculée par rapport au poids total de la composition photosensible.

De préférence, ces compositions photosensibles contiennent une quantité de 48 à 90% en poids de résine phénolique et de 8 à 45% en poids de dérivé de diazoquinone calculée par rapport au poids total de la composition photosensible.

Des additifs tels que des colorants, des teintures, des agents anti-stries, des agents modificateurs de l'écoulement, des régulateurs du taux d'évaporation du solvant et des promoteurs d'adhésion peuvent être ajoutés aux compositions photosensibles conformément à la présente invention. Ces additifs peuvent en général être utilisés en une quantité variant entre environ 20 ppm et environ 20% en poids calculée par rapport au poids total de la composition photosensible.

L'addition de colorants qui absorbent la lumière à une longueur d'onde de 350 à 500 nm aux compositions photosensibles de la présente invention limitera l'exposition à la lumière à la partie supérieure de la couche de photorésist. C'est pourquoi, l'addition de ces colorants aux compositions photosensibles de la présente invention est très avantageuse, particulièrement lorsque ces compositions sont destinées à être utilisées dans un procédé tel que décrit dans la demande de brevet européen 184.567 mentionnée plus haut, où la formation de l'image doit se faire seulement à la partie supérieure de la couche de photorésist (et non à travers toute son épaisseur comme dans les systèmes de résist développés par voie humide). Comme il est montré dans les exemples de réalisation ci-après, l'addition de 1 à 20% en poids d'un colorant absorbant à une longueur d'onde de 350 à 500 nm a un effet très favorable sur le contrôle de la largeur des lignes, particulièrement sur des substrats à topographie de surface. Comme exemples de colorants qui peuvent être utilisés dans les compositions photosensibles de la présente invention, on peut citer les colorants azoïques, comme le phénylazorésorcinol (4-(phénylazo)-1,3-benzènediol), le 4-(phénylazo)phénol, la curcumine et d'autres colorants tels que ceux vendus sous les dénominations commerciales de Macrolex 6G (BAYER), Neopen Gelb 075 (BASF), etc.

Les compositions photosensibles selon la présente invention sont dissoutes dans un solvant approprié capable de solubiliser tous les composants mentionnés ci-dessus, avant de les appliquer sur un support approprié pour former le photorésist. Un soin tout particulier doit être apporté au choix du solvant ou du mélange de solvants pour assurer une dissolution complète des divers composants du résist et des additifs, une stabilité au stockage de longue durée et un bon taux d'écoulement et d'évaporation. Comme exemples de solvants qui peuvent être utilisés, on peut citer les éthers de glycols, comme l'éthylène glycol méthyl ou éthyl éther, le propylène glycol méthyl ou éthyl éther, les acétates correspondants comme l'éthylène glycol méthyl ou éthyl éther acétate, le propylène glycol méthyl ou éthyl éther acétate, les cétones, les esters de l'acide acétique ou de l'acide lactique avec des alcools aliphatiques, les carbonates d'éthylène ou de propylène, les bis(alkoxy)dialkyléthers, les éthers cycliques tels que le dioxanne, le tétrahydrofuranne ou ses dérivés, la 1,3-diméthyl-2-imidazolidinone, la gamma-butyrolactone, la N-méthyl-pyrrolidone, le diméthylformamide, le diméthylsulfoxyde, etc. Ces solvants peuvent être utilisés individuellement ou en mélanges. Habituellement, une quantité de 5 à 75 parties en poids de la composition photosensible selon l'invention est dissoute dans 100 parties en poids de solvant.

Comme on peut le comprendre aisément de la description qui précède, les compositions photosensibles selon la présente invention conviennent particulièrement bien pour être utilisées comme photorésists dans un procédé de formation de motifs tel que décrit dans la demande de brevet européen 184.567. Dans cette application particulière, une couche d'une composition photosensible est appliquée sur un substrat, par exemple, une tranche de silicium/dioxyde de silicium ou une tranche recouverte de métal, après qu'une telle composition fut dissoute dans un solvant comme cité précédemment. Ensuite, la tranche enduite est cuite (de 50 à 150°C, de préférence de 80 à 120°C, pendant une durée variant de quelques secondes jusqu'à 60 minutes), la couche est exposée à travers un masque à un rayonnement ultraviolet de longueur d'onde appropriée (par exemple de 100 à 500 nm). La couche ainsi exposée est ensuite traitée avec un composé de silicium en phase liquide ou vapeur (par exemple tout agent de silylation mentionné ci-dessus), à une température qui peut varier entre environ 10 et environ 190°C pendant une durée allant de quelques secondes jusqu'à 60 minutes. Le composé de silicium est incorporé sélectivement dans les parties irradiées de l'enduit et réagit avec les groupes hydroxyles fonctionnels de la résine phénolique dans ces parties irradiées. La couche ainsi

traitée est ensuite développée par des techniques de gravure sèche comme la gravure au plasma d'oxygène, la gravure par ions réactifs d'oxygène, etc. Lorsqu'elles sont utilisées dans ce procédé, les compositions photosensibles selon la présente invention produisent de manière surprenante des valeurs de contraste élevées (par exemple aussi élevées que 11) et en même temps, des valeurs de sélectivité élevées (par exemple 22-23). Après développement par voie sèche, on obtient des motifs négatifs d'excellente qualité avec des profils raides et un excellent contrôle de la largeur des lignes; aucun résidu n'est présent dans les zones dénudées, où les parties non irradiées ont été éliminées. De plus, comme il a déjà été expliqué plus haut, une autre caractéristique avantageuse des compositions de la présente invention est que ces valeurs de contraste et de sélectivité élevées sont obtenues à des températures de silylation plus basses en comparaison avec les compositions de l'état antérieur de la technique à base de résines phénoliques et de diazoquinones. Les exemples qui suivent sont donnés dans le but d'illustrer l'invention sans la limiter.

Exemple 1.

(a) Préparation de la résine photosensible (novolaque + diazoquinone).

Dans un ballon d'un litre à 3 cols muni d'un réfrigérant à reflux et d'un thermomètre, on place 120 g de p-tert.-butylphénol, 300 g de phénol, 78 g de paraformaldéhyde, 97 g d'une solution aqueuse à 37% de formaldéhyde et 3,8 g d'acide oxalique. On chauffe le mélange à reflux à 100°C pendant 3 heures. Ensuite, on élimine l'eau du mélange réactionnel sous pression réduite dans un évaporateur rotatif conventionnel. L'excès de phénol est ensuite éliminé en chauffant le mélange à 190°C sous pression réduite. On obtient 436 g d'une résine novolaque (rapport molaire du phénol au p-tert.-butylphénol = 80:20). Finalement, une résine photosensible est préparée par estérification de la résine novolaque obtenue avec le chlorure de 6-diazo-5,6-dihydro-5-oxo-1-naphtalènesulfonyle dans un rapport en poids de 5 à 1,3.

(b) Préparation de l'acide 6-diazo-5,6-dihydro-5-oxo-1-naphtalènesulfonique.

20 g du sel sodique de l'acide 6-diazo-5,6-dihydro-5-oxo-1-naphtalènesulfonique sont dissous dans 100 g d'eau déminéralisée. La solution est passée sur une résine échangeuse d'ions cationique et est ensuite concentrée par évaporation. Le produit concentré contient moins de 100 ppm de sodium, indiquant que la conversion du sel en acide libre est presque complète.

(c) Influence de l'addition de quantités croissantes d'acide sur les propriétés des compositions photosensibles.

Avec la résine photosensible préparée en 1(a) ci-dessus, on prépare une solution ayant la composition suivante:

30 g de l'ester partiel de la résine novolaque avec le chlorure de 6-diazo-5,6-dihydro-5-oxo-1-naphtalène-sulfonyle,
70 g de propylène glycol méthyl éther acétate.

On effectue cinq essais en parallèle en utilisant chaque fois la solution décrite ci-dessus. Dans l'essai 1, la solution ci-dessus est utilisée comme contrôle tandis que dans les essais 2 à 5, on utilise des solutions auxquelles on ajoute des quantités croissantes d'acide 6-diazo-5,6-dihydro-5-oxo-1-naphtalène-sulfonique comme préparé en 1(b) ci-dessus. Les quantités d'acide présentes dans chaque solution testée sont indiquées dans le tableau I ci-après; ces quantités sont exprimées en % en poids des composants solides de la solution. Dans chacun de ces essais, la solution est enduite par centrifugation sur différentes tranches de silicium et les tranches enduites sont cuites à 90°C sur une plaque chaude pendant 60 secondes. L'épaisseur du film de résist sec est de 1,8 µm. Les tranches de silicium sont ensuite exposées selon le motif à travers un masque en utilisant de la lumière UV d'une longueur d'onde d'environ 436 nm dans une matrice d'exposition variant de O à 300 mJ/cm2. Les tranches de silicium exposées sont ensuite traitées par des vapeurs d'hexaméthyldisilazane pendant 2 minutes, à des températures variant entre 120 et 160°C. Ce traitement est effectué dans une chambre de réaction qui, après l'introduction de la tranche, est partiellement mise sous vide et portée à une température stable avant l'introduction des vapeurs d'hexaméthyldisilazane. Avant d'enlever la tranche de silicium de la chambre de réaction, celle-ci est à nouveau partiellement mise sous vide et purgée avec de l'azote. Finalement, les tranches ainsi traitées sont gravées dans un plasma d'oxygène anisotrope, en appliquant une surgravure de 30%.

Pour chaque solution testée, on établit une courbe de contraste qui représente l'épaisseur résiduelle du film après développement en fonction du logarithme de la dose d'exposition UV et on détermine le contraste à partir de la pente de la partie linéaire de la courbe de contraste. De façon analogue, pour chaque solution testée, on détermine la sélectivité à partir de l'épaisseur initiale du film et de l'épaisseur résiduelle mesurée après développement du résist exposé. Au tableau 1, on montre les valeurs du contraste et de la sélectivité pour chaque solution testée. Pour chaque

solution, on indique également la température de silylation à laquelle ces valeurs sont obtenues.

Tableau I

| Essai | Quantité d'acide (en % en poids) | Température de silylation (%C) | Contraste | Sélectivité |
|---|---|---|---|---|
| 1 | 0 | 160 | 2,9 | 15 |
| 2 | 0,1 | 145 | 4,2 | 18 |
| 3 | 0,25 | 135 | 7,5 | 22 |
| 4 | 0,5 | 130 | 10,5 | 23 |
| 5 | 1 | 120 | 11 | 22 |

Les résultats montrent que l'addition de faibles quantités d'acide 6-diazo-5,6-dihydro-5-oxo-1-naphtalènesulfonique augmente considérablement le contraste de la composition de résist. Ainsi, alors qu'en l'absence d'acide, le contraste est seulement de 2,9 (essai 1), le contraste est de 10,5 lorsque la composition contient 0,5% en poids d'acide (essai 4) et atteint même 11 lorsque la composition contient 1% en poids d'acide (essai 5). En outre, le Tableau I montre qu'il y a en même temps une augmentation légère mais significative de la sélectivité en passant d'une valeur de 15 (essai 1) à 22-23 (essais 3 à 5). Les résultats montrent également que bien qu'un contraste important et une grande sélectivité sont obtenus lorsqu'on ajoute de faibles quantités d'acide, la température exigée pour l'étape de silylation est inférieure (120-130°C) aux températures exigées pour les compositions dans lesquelles aucun acide n'est ajouté (160°C).

Exemple 2.

30 g de la résine photosensible préparée dans l'exemple 1(a) sont dissous dans 70 g de propylène glycol méthyl éther acétate et on ajoute de l'acide 2-naphtalènesulfonique à cette solution à raison de 1% en poids des composants solides de la solution. Cette solution est enduite par centrifugation sur des tranches de silicium et les tranches enduites sont cuites à 90°C sur une plaque chaude pendant 60 secondes. L'épaisseur du film de résist sec est de 1,8 μm. Les tranches sont ensuite exposées selon le motif à travers un masque à de la lumière UV d'une longueur d'onde de 365 nm. Les tranches exposées sont ensuite traitées par des vapeurs d'hexaméthyldisilazane, à des températures variant entre 120 et 160°C de la même façon que dans l'exemple 1. Finalement, les tranches ainsi traitées sont gravées dans un plasma d'oxygène anisotrope, en appliquant une surgravure de 30%.

On obtient un motif constitué de lignes et d'espaces égaux de 0,5 μm avec des espaces nets, exempts de résidus, à une température de silylation de 130°C. Lorsqu'on compare ces résultats avec ceux de l'essai comparatif 1 (voir exemple 1(c)), dans lequel la composition photosensible ne contient pas d'acide, on peut voir que l'addition de 1% en poids d'acide 2-naphtalènesulfonique permet une diminution de la température de silylation de 30°C (130°C au lieu de 160°C).

Exemple 3.

30 g de résine photosensible préparée dans l'exemple 1(a) sont dissous dans 70 g de 1,3-diméthyl-2-imidazolidinone. Cette solution est divisée en deux parties égales, qui sont traitées comme suit:

- la première est utilisée telle quelle,
- à la seconde partie, on ajoute de l'acide 6-diazo-5,6-dihydro-5-oxo-1-naphtalènesulfonique (préparé comme dans l'exemple 1(b)) à raison de 1% en poids des composants solides de la solution.

Les deux solutions ainsi obtenues sont enduites par centrifugation sur des tranches de silicium et les tranches enduites sont cuites à 90°C sur une plaque chaude durant 60 secondes. L'épaisseur du film de résist sec est de 2 μm. Les tranches sont ensuite exposées selon le motif à travers un masque à de la lumière UV à d'une longueur d'onde d'environ 365 nm. Les tranches exposées sont ensuite traitées par des vapeurs d'hexaméthyldisilazane, à une température de 130°C pendant 2 minutes. Finalement, les tranches sont gravées dans un plasma d'oxygène anisotrope, en appliquant une surgravure de 30%.

Après le développement au plasma, la première solution qui ne contient pas d'acide ne produit aucune image. Pendant le développement au plasma, le résist a été complètement éliminé du substrat. D'autre part, la deuxième solution fournit un motif bien défini. On peut conclure qu'aucune silylation appréciable ne se produit à 130°C lorsqu'on utilise la première solution, qui ne contient aucun additif acide. Comme il a déjà été démontré dans l'exemple 1(c), une température de silylation de 160°C doit être utilisée pour obtenir un motif avec une telle solution. D'autre part, comme

il l'a été démontré ci-dessus, on obtient des motifs d'excellente qualité par l'addition de 1% en poids d'acide 6-diazo-5,6-dihydro-5-oxo-1-naphtalènesulfonique, même à une température de silylation de 130°C.

Exemple 4.

Une solution est préparée comme décrite à l'exemple 1(c) et à cette solution, on ajoute de l'acide 6-diazo-5,6-dihydro-5-oxo-1-naphtalènesulfonique à raison de 0,5% en poids des composants solides de la solution. Cette solution est enduite par centrifugation sur des tranches de silicium avec une couche d'aluminium présentant des gradins de 1 µm de hauteur. Les tranches ainsi enduites sont cuites à 90°C sur une plaque chaude pendant 60 secondes. L'épaisseur du film de résist sec est de 2 µm. Les tranches sont ensuite exposées selon le motif à travers un masque à de la lumière UV d'une longueur d'onde d'environ 436 nm et à une dose d'exposition de 150 mJ/cm2. Les tranches exposées sont ensuite traitées par des vapeurs d'hexaméthyldisilazane à une température de 130°C pendant 2 minutes. Finalement, les tranches sont gravées dans un plasma d'oxygène anisotrope. La largeur des lignes des motifs nominaux de 1 µm est mesurée sur les gradins et entre les gradins, de telle sorte que les largeurs des lignes minimum et maximum sont enregistrées. La différence entre les largeurs des lignes maximum et minimum est le changement de largeur des lignes ($delta_{CD}$) causé par le gradin dans le substrat. Une valeur pour $delta_{CD}$ de 0,3 µm est obtenue avec la solution utilisée ci-dessus.

On répète la même expérience en suivant exactement les mêmes procédures, mais on ajoute de petites quantités de différents colorants à la solution d'enduction. La nature et la quantité de colorant présent dans chaque solution testée sont indiquées dans le Tableau II ci-dessous, ces quantités étant exprimées en % en poids de la solution.

Ce tableau II montre l'effet des différents colorants sur le changement de largeur des lignes ($delta_{CD}$ en µm) et sur les valeurs des angles des parois latérales des motifs obtenus.

Tableau II

| Colorant | Quantité de colorant (% en poids) | $delta_{CD}$(µm) | Angle des parois latérales (°) |
|---|---|---|---|
| - | 0 | 0,3 | 86 |
| 4-(phénylazo)-1,3-benzènediol | 0,4 | 0,22 | 84 |
| Curcumine | 0,5 | 0,15 | 87 |
| Curcumine | 1,5 | 0,03 | 86 |
| Macrolex 6G (1) | 2 | 0,11 | 84 |
| Neopen Gelb (2) | 2 | 0,04 | 85 |
| Neopen Gelb 075 (2) | 6 | 0,03 | 87 |

(1) Marque commerciale de BAYER A.G.
(2) Marque commerciale de BASF A.G.

Comme seulement une mince couche supérieure doit être exposée, la plus grande absorption due à l'addition des colorants n'aura pas d'influence sur la photosensibilité et sur les pentes du résist, contrairement aux photorésists normaux, développés par voie humide, dans lesquelles l'exposition jusqu'au fond de la couche de résist est essentielle pour obtenir un développement complet.

Comme il ressort du Tableau II, l'addition de colorants aux compositions photosensibles de la présente invention a un effet très favorable en permettant un excellent contrôle de la largeur des lignes sur des substrats avec topographie de surface sans effet néfaste sur les profils du résist (les angles des parois latérales restent constants).

Exemple 5.

La résine photosensible utilisée est préparée par estérification de poly(vinylphénol), commercialisé par MARUZEN C°, Japon, avec le chlorure de 3-diazo-3,4-dihydro-4-oxo-1-naphtalènesulfonyle dans un rapport en poids de 5 à 1,5. 30 g de cette résine et 0,3 g d'acide 3-diazo-3,4-dihydro-4-oxo-1-naphtalènesulfonique sont dissous dans 70 g de propylène glycol méthyl éther acétate. Cette solution est enduite par centrifugation sur plusieurs tranches de silicium et les tranches enduites sont cuites à 90°C sur une plaque chaude pendant 60 secondes (épaisseur du film: 1,7µm). Les tranches sont ensuite exposées selon le motif à travers un masque à de la lumière UV d'une longueur d'onde de 248 nm dans une matrice d'exposition variant de 0 à 300 mJ/cm2.

Les tranches exposées sont ensuite traitées par des vapeurs d'hexaméthyldisilazane à des températures comprises entre 120 et 160°C. Ensuite, les tranches sont gravées dans un plasma d'oxygène anisotrope en appliquant une surgravure de 30%. On obtient des motifs à haute résolution avec des surfaces lisses et des parois latérales

verticales à une dose d'exposition de 120 mJ/cm2 et à une température de silylation de 150°C.

Exemple 6.

30 g de la résine photosensible préparée dans l'exemple 1(a) sont dissous dans 70 g de lactate d'éthyle. On ajoute à cette solution chacun des acides énumérés au Tableau III, à raison de 5% en poids des composants solides de la solution. Les solutions ainsi obtenues sont enduites par centrifugation sur des tranches de silicium et les tranches enduites sont cuites à 90°C sur une plaque chaude pendant 60 secondes.

L'épaisseur du film de résist sec est de 1,7 µm chaque fois. Les tranches sont ensuite exposées selon le motif à travers un masque à de la lumière UV d'une longueur d'onde de 365 nm. Les tranches exposées sont ensuite traitées par des vapeurs d'hexaméthyldisilazane, à des températures variant entre 120 et 160°C de la même façon que dans l'exemple 1. Finalement, les tranches ainsi traitées sont gravées dans un plasma d'oxygène anisotrope, en appliquant une surgravure de 30%.

Le Tableau III donne pour chaque solution la température de silylation requise pour obtenir un motif constitué de lignes et d'espaces égaux de 0,5 µm.

Tableau III

| Acide | Température de silylation (°C) |
|---|---|
| Acide picrique (comparatif) | 160°C |
| Acide nicotinique (comparatif) | 160°C |
| Acide 2,4-dihydroxybenzoïque (comparatif) | 160°C |
| Acide 4-amino-1-naphtalènesulfonique (comparatif) | 160°C |
| Acide 1-naphtalènesulfonique | 145°C |
| Acide 2-naphtalènesulfonique | 130°C |
| Acide 6-diazo-5,6-dihydro-5-oxo-1-naphtalènesulfonique | 130°C |
| Acide 3-diazo-3,4-dihydro-4-oxo-1-naphtalènesulfonique | 130°C |

Ces résultats montrent très clairement que la nature de l'acide est importante pour obtenir un abaissement de la température de silylation. C'est ainsi qu'avec les solutions renfermant des acides aromatiques ou hétérocycliques, comme l'acide picrique et l'acide nicotinique (comme décrit dans le brevet américain 4.009.033) une température de silylation de 160°C doit être utilisée pour obtenir des motifs. Il en va de même pour des acides aminés aromatiques tels que l'acide 4-amino-1-naphtalènesulfonique. A l'inverse, de meilleurs motifs sont obtenus par l'addition de 5% en poids d'acide 1-naphtalènesulfonique, d'acide 2-naphtalènesulfonique, d'acide 6-diazo-5,6-dihydro-5-oxo-1-naphtalènesulfonique et d'acide 3-diazo-3,4-dihydro-4-oxo-1-naphtalènesulfonique, même à une température de silylation de 130°C.

Exemple 7.

30 g de la résine photosensible préparée dans l'exemple 1(a) sont dissous dans 70 g de 1,3-diméthyl-2-imidazolidinone. On ajoute le sel d'ammonium de l'acide 6-diazo-5,6-dihydro-5-oxo-1-naphtalènesulfonique à cette solution à raison de 0,5% en poids des composants solides de la solution. Cette solution est enduite par centrifugation sur des tranches de silicium et les tranches enduites sont cuites à 90°C sur une plaque chaude pendant 60 secondes. L'épaisseur du film de résist sec est de 1,9 µm. Les tranches sont ensuite exposées selon le motif à travers un masque à de la lumière UV d'une longueur d'onde de 365 nm. Les tranches exposées sont ensuite traitées par des vapeurs d'hexaméthyldisilazane, à des températures variant entre 120 et 160°C de la même façon que dans l'exemple 1. Finalement les tranches ainsi traitées sont gravées dans un plasma d'oxygène anisotrope, en appliquant une surgravure de 30%.

On obtient des motifs présentant une haute résolution, avec des lignes et des espaces égaux, avec des espaces propres, dépourvus de résidus, à une température de silylation de 140°C.

Exemple 8.

30 g de la résine photosensible préparée dans l'exemple 1(a) sont dissous dans 70 g de N-méthylpyrrolidone. On ajoute le sel de triméthylammonium de l'acide 3-diazo-3,4-dihydro-4-oxo-1-naphtalènesulfonique à cette solution à raison de 1% en poids des composants solides de la solution. Cette solution est enduite par centrifugation sur des tranches de silicium et les tranches enduites sont cuites à 90°C sur une plaque chaude pendant 60 secondes. L'épaisseur du film de résist sec est de 1,9 µm. Les tranches sont ensuite exposées selon le motif à travers un masque à de la lumière UV d'une longueur d'onde de 365 nm. Les tranches exposées sont ensuite traitées par des vapeurs d'hexaméthyldisilazane, à des températures variant entre 120 et 160°C de la même façon que dans l'exemple 1. Finalement, les tranches ainsi traitées sont gravées dans un plasma d'oxygène anisotrope, en appliquant une surgravure de 30%.

On obtient des motifs présentant une haute résolution, avec des lignes et des espaces égaux, avec des espaces propres, dépourvus de résidus, à une température de silylation de 130°C.

Exemple 9.

30 g de la résine photosensible préparée dans l'exemple 1(a) sont dissous dans 70 g de 1,3-diméthyl-2-imidazolidinone. On ajoute le sel d'ammonium de l'acide 2-naphtalènesulfonique à cette solution à raison de 2% en poids des composants solides de la solution. Cette solution est enduite par centrifugation sur des tranches de silicium et les tranches enduites sont cuites à 90°C sur une plaque chaude pendant 60 secondes. L'épaisseur du film de résist sec est de 1,9 µm. Les tranches sont ensuite exposées selon le motif à travers un masque à de la lumière UV d'une longueur d'onde de 365 nm. Les tranches exposées sont ensuite traitées par des vapeurs d'hexaméthyldisilazane, à des températures variant entre 120 et 160°C de la même façon que dans l'exemple 1. Finalement, les tranches ainsi traitées sont gravées dans un plasma d'oxygène anisotrope, en appliquant une surgravure de 30%.

On obtient des motifs présentant une haute résolution, avec des lignes et des espaces égaux, avec des espaces propres, dépourvus de résidus, à une température de silylation de 130°C.

Example 10.

30 g de la résine photosensible préparée dans l'exemple 1(a) sont dissous dans 70 g de N-méthylpyrrolidone. On ajoute le sel de diméthylammonium de l'acide 2-naphtalènesulfonique à cette solution à raison de 2% en poids des composants solides de la solution. Cette solution est enduite par centrifugation sur des tranches de silicium et les tranches enduites sont cuites à 90°C sur une plaque chaude pendant 60 secondes. L'épaisseur du film de résist sec est de 1,9 µm. Les tranches sont ensuite exposées selon le motif à travers un masque à de la lumière UV d'une longueur d'onde de 365 nm. Les tranches exposées sont ensuite traitées par des vapeurs d'hexaméthyldisilazane, à des températures variant entre 120 et 160°C de la même façon que dans l'exemple 1. Finalement, les tranches ainsi traitées sont gravées dans un plasma d'oxygène anisotrope, en appliquant une surgravure de 30%.

On obtient des motifs présentant une haute résolution, avec des lignes et des espaces égaux, avec des espaces propres, dépourvus de résidus, à une température de silylation de 140°C.

## Revendications

1. Composition photosensible comprenant au moins une résine phénolique, au moins un dérivé de diazoquinone sous la forme d'un ester partiel d'un acide diazoquinone-sulfonique ou -carboxylique et de la résine phénolique et au moins un acide sulfonique ou carboxylique aromatique polycyclique condensé, sous la forme de l'acide libre et/ou d'un sel d'ammonium, le cation du sel d'ammonium avant la formule

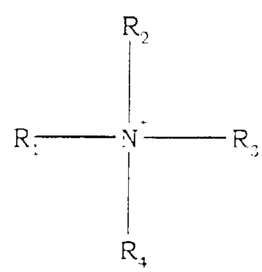

dans laquelle $R_1$, $R_2$, $R_3$ et $R_4$, qui peuvent être identiques ou différents, représentent chacun un atome d'hydrogène ou un groupe alkyle ou hydroxyalkyle contenant de 1 à 4 atomes de carbone, avec la restriction que l'acide sulfonique ou carboxylique aromatique est autre qu'un acide aminé aromatique et que l'acide coumarilique.

2. Composition selon la revendication 1, caractérisée en ce que l'acide sulfonique ou carboxylique aromatique polycyclique condensé est choisi dans le groupe consistant en

l'acide 1-naphtalènesulfonique,
l'acide 2-naphtalènesulfonique,
l'acide 3-diazo-3,4-dihydro-4-oxo-1-naphtalènesulfonique,
l'acide 6-diazo-5,6-dihydro-5-oxo-1-naphtalènesulfonique,
l'acide 6-diazo-5,6-dihydro-5-oxo-2-naphtalènesulfonique,
l'acide 4-diazo-3,4-dihydro-3-oxo-1-naphtalènesulfonique,
l'acide 5-diazo-5,6-dihydro-6-oxo-1-naphtalènesulfonique,
l'acide 5-diazo-5,6-dihydro-6-oxo-2-naphtalènesulfonique,
les acides carboxyliques correspondants et les mélanges d'au moins deux de ces composés.

3. Composition selon la revendication 1, caractérisée en ce que l'acide sulfonique ou carboxylique aromatique polycyclique condensé est un acide diazoquinone-sulfonique représenté par la formule

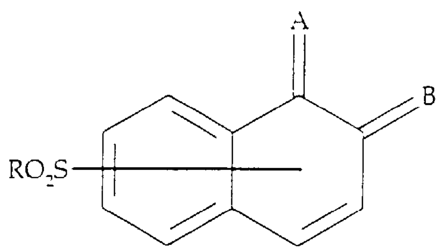

dans laquelle A représente $N_2$ ou O et B est O lorsque A est $N_2$ ou B est $N_2$ lorsque A est O et R représente OH ou OM, où M est un ion ammonium ou ammonium substitué.

4. Composition selon l'une quelconque des revendications 1 à 3, caractérisée en ce que l'acide sulfonique ou carboxylique aromatique polycyclique condensé est présent en une quantité d'environ 0,01 à environ 24% en poids calculée par rapport au poids total de la composition.

5. Composition selon l'une quelconque des revendications 1 à 4, caractérisée en ce que l'acide sulfonique ou carboxylique aromatique polycyclique condensé est présent en une quantité d'environ 0,05 à environ 10% en poids calculée par rapport au poids total de la composition.

6. Composition selon l'une quelconque des revendications 1 à 5, caractérisée en ce que l'acide sulfonique ou carboxylique aromatique polycyclique condensé est présent en une quantité de 0,2 à 2% en poids calculée par rapport au poids total de la composition.

7. Composition selon l'une quelconque des revendications 1 à 6, caractérisée en ce que l'acide sulfonique ou carboxylique aromatique polycyclique condensé est présent sous la forme d'un sel d'ammonium dont le cation est choisi parmi ceux représentés par la formule

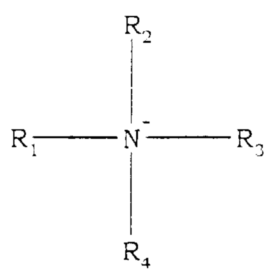

dans laquelle $R_1$, $R_2$, $R_3$ et $R_4$, qui peuvent être identiques ou différents, représentent chacun un atome d'hydrogène ou un groupe alkyle ou hydroxyalkyle contenant de 1 à 4 atomes de carbone.

8. Composition selon l'une quelconque des revendications 1 à 6, caractérisée en ce que l'acide sulfonique ou carboxylique aromatique polycyclique condensé est présent sous la forme de l'acide libre.

9. Composition selon l'une quelconque des revendications 1 à 8, caractérisée en ce que la résine phénolique est un poly(vinylphénol), une novolaque obtenue par condensation d'un phénol, d'un mono-, di-, ou trialkylphénol, d'un arylphénol, d'un naphtol non-substitué, d'un naphtol substitué, d'un résorcinol, d'un résorcinol alkyl-substitué, d'un pyrogallol, d'un pyrogallol alkyl-substitué ou d'un mélange de ces composés avec du formaldéhyde, de l'acétaldéhyde, du benzaldéhyde ou leurs mélanges, ou un mélange de deux ou plusieurs de ces résines.

10. Composition selon l'une quelconque des revendications 1 à 9, caractérisée en ce que la résine phénolique est une novolaque co-condensée obtenue par condensation de formaldéhyde avec un mélange de phénol et de p-tert.-butylphénol dans lequel le rapport molaire du p-tert.-butylphénol au phénol est de 1:10 à 10:1.

11. Composition selon l'une quelconque des revendications 1 à 10, caractérisée en ce que la résine phénolique est présente en une quantité d'environ 30 à environ 95% en poids et le dérivé de diazoquinone est présent en une quantité d'environ 4 à environ 60% en poids calculée par rapport au poids total de la composition.

12. Composition selon l'une quelconque des revendications 1 à 11, caractérisée en ce que la résine phénolique est présente en une quantité d'environ 48 à environ 90% en poids et le dérivé de diazoquinone est présent en une quantité d'environ 8 à environ 45% en poids calculée par rapport au poids total de la composition.

13. Composition selon l'une quelconque des revendications 1 à 12, caractérisée en ce qu'elle contient en outre un colorant absorbant la lumière à une longueur d'onde de 350 à 500 nm.

14. Composition selon l'une quelconque des revendications 1 à 13, caractérisée en ce qu'elle contient en outre un solvant ou un mélange de solvants.

15. Procédé de formation de motifs négatifs sur un substrat comprenant les stades suivants:

(a) le recouvrement du substrat par une couche de composition photosensible qui comprend au moins une résine phénolique et au moins un dérivé de diazoquinone sous la forme d'un ester partiel d'un acide diazoquinone-sulfonique ou - carboxylique et de la résine phénolique;
(b) l'exposition de cette couche à un rayonnement ultraviolet à travers un masque, de façon à ce que seules les parties voulues de la couche soient exposées;
(c) le traitement de la couche ainsi exposée par un composé de silicium, de manière à ce que ledit composé de silicium soit sélectivement absorbé dans les parties irradiées de la couche;
(d) le développement de la couche ainsi traitée en utilisant les techniques de gravure par voie sèche de manière à enlever sélectivement les parties non irradiées de la couche pour obtenir les motifs négatifs, caractérisé en ce que l'on ajoute à la composition photosensible au moins un acide sulfonique ou carboxylique aromatique polycyclique condensé, sous la forme de l'acide libre et/ou d'un sel d'ammonium, le cation du sel d'ammonium ayant la formule

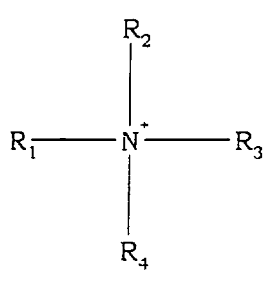

dans laquelle $R_1$, $R_2$, $R_3$ et $R_4$, qui peuvent être identiques ou différents, représentent chacun un atome d'hydrogène ou un groupe alkyle ou hydroxyalkyle contenant de 1 à 4 atomes de carbone, avec la restriction que l'acide sulfonique ou carboxylique aromatique est autre qu'un acide aminé aromatique et que l'acide coumarilique.

16. Procédé selon la revendication 15, caractérisé en ce que l'acide sulfonique ou carboxylique aromatique polycyclique condensé est choisi dans le groupe consistant en

l'acide 1-naphtalènesulfonique,

l'acide 2-naphtalènesulfonique,
l'acide 3-diazo-3,4-dihydro-4-oxo-1-naphtalènesulfonique,
l'acide 6-diazo-5,6-dihydro-5-oxo-1-naphtalènesulfonique,
l'acide 6-diazo-5,6-dihydro-5-oxo-2-naphtalènesulfonique,
l'acide 4-diazo-3,4-dihydro-3-oxo-1-naphtalènesulfonique,
l'acide 5-diazo-5,6-dihydro-6-oxo-1-naphtalènesulfonique,
l'acide 5-diazo-5,6-dihydro-6-oxo-2-naphtalènesulfonique,
les acides carboxyliques correspondants et les mélanges d'au moins deux de ces composés.

**17.** Procédé selon la revendication 15, caractérisé en ce que l'acide sulfonique ou carboxylique aromatique polycyclique condensé est un acide diazoquinone-sulfonique représenté par la formule suivante:

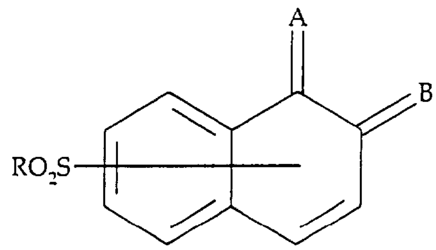

dans laquelle A représente $N_2$ ou O et B est O lorsque A est $N_2$ ou B est $N_2$ lorsque A est O et R représente OH ou OM, où M est un ion ammonium ou ammonium substitué.

**18.** Procédé selon l'une quelconque des revendications 15 à 17, caractérisé en ce que l'acide sulfonique ou carboxylique aromatique polycyclique condensé est ajouté à la composition photosensible en une quantité de 0,01 à environ 24% en poids calculée par rapport au poids total de la composition.

**19.** Circuit intégré fabriqué au moyen du procédé selon l'une quelconque des revendications 15 à 18.

**Patentansprüche**

**1.** Lichtempfindliche Zusammensetzung, die wenigstens ein Phenolharz, wenigstens ein Diazochinonderivat in Form eines Teilesters einer Diazochinonsulfonsäure oder -carbonsäure und des Phenolharzes und wenigstens eine kondensierte, polycyclische, aromatische Sulfon- oder Carbonsäure umfaßt, in Form der freien Säure und/oder eines Ammoniumsalzes, wobei das Kation des Ammoniumsalzes die Formel:

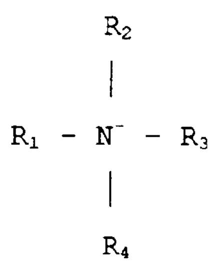

aufweist, in der $R_1$, $R_2$, $R_3$ und $R_4$, die gleich oder unterschiedlich sein können, jeweils ein Wasserstoffatom oder eine Alkyl- oder Hydroxyalkygruppe mit 1 bis 4 Kohlenstoffatomen darstellen, mit der Einschränkung, daß die aromatische Sulfon- oder Carbonsäure keine aromatische Aminosäure und keine Cumarinsäure ist.

**2.** Zusammensetzung nach Anspruch 1, dadurch gekennzeichnet, daß die kondensierte polycyclische Sulfon- oder Carbonsäure ausgewählt ist aus der Gruppe bestehend aus

1-Naphthalinsulfonsäure,
2-Naphthalinsulfonsäure,

3-Diazo-3,4-dihydro-4-oxo-1-naphthalinsulfonsäure,
6-Diazo-5,6-dihydro-5-oxo-1-naphthalinsulfonsäure,
6-Diazo-5,6-dihydro-5-oxo-2-naphthalinsulfonsäure,
4-Diazo-3,4-dihydro-3-oxo-1-naphthalinsulfonsäure,
5-Diazo-5,6-dihydro-6-oxo-1-naphthalinsulfonsäure,
5-Diazo-5,6-dihydro-6-oxo-2-naphthalinsulfonsäure,

den entsprechenden Carbonsäuren und den Mischungen von wenigstens zwei dieser Verbindungen.

**3.** Zusammensetzung nach Anspruch 1, dadurch gekennzeichnet, daß die kondensierte polycylische aromatische Sulfon- oder Carbonsäure eine Diazochinonsulfonsäure der Formel

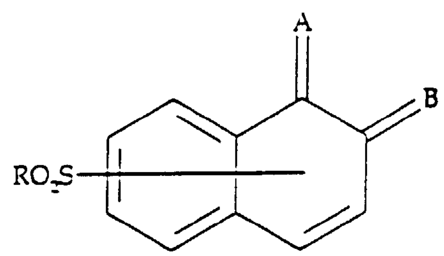

ist, worin A $N_2$ oder O darstellt und B gleich O ist, wenn A gleich $N_2$ ist oder B gleich $N_2$ ist, wenn A gleich O ist und R OH oder OM bedeutet, wobei M ein Ammonium- oder substituiertes Ammoniumion ist.

**4.** Zusammensetzung nach einem der Ansprüche 1 bis 3, dadurch gekennzeichnet, daß die kondensierte polycyclische aromatische Sulfon- oder Carbonsäure in einer Menge von ungefähr 0,01 bis ungefähr 24 Gew.-%, berechnet bezogen auf das Gesamtgewicht der Zusammensetzung, vorhanden ist.

**5.** Zusammensetzung nach einem der Ansprüche 1 bis 4, dadurch gekennzeichnet, daß die kondensierte polycyclische aromatische Sulfon- oder Carbonsäure in einer Menge von etwa 0,05 bis etwa 10 Gew.-%, berechnet bezogen auf das Gesamtgewicht der Zusammensetzung, vorhanden ist.

**6.** Zusammensetzung nach einem der Ansprüche 1 bis 5, dadurch gekennzeichnet, daß die kondensierte polycyclische aromatische Sulfon- oder Carbonsäure in einer Menge von 0,2 bis 2 Gew.-%, berechnet bezogen auf das Gesamtgewicht der Zusammensetzung, vorhanden ist.

**7.** Zusammensetzung nach einem der Ansprüche 1 bis 6, dadurch gekennzeichnet, daß die kondensierte polycyclische aromatische Sulfon- oder Carbonsäure in Form eines Ammoniumsalzes vorhanden ist, dessen Kation ausgewählt ist aus solchen mit der Formel

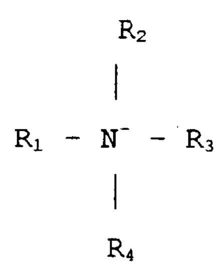

worin $R_1$, $R_2$ $R_3$ und $R_4$, die gleich oder unterschiedlich sein können, jeweils ein Wasserstoffatom oder eine Alkyl- oder Hydroxyalkylgruppe mit 1 bis 4 Kohlenstoffatomen darstellen.

**8.** Zusammensetzung nach einem der Ansprüche 1 bis 6, dadurch gekennzeichnet, daß die kondensierte polycyclische aromatische Sulfon- oder Carbonsäure in Form der freien Säure vorhanden ist.

**9.** Zusammensetzung nach einem der Ansprüche 1 bis 8, dadurch gekennzeichnet, daß das Phenolharz ein Poly (vinylphenol), ein Novolak, der durch Kondensation eines Phenols, eines Mono-, Di- oder Trialkylphenols, eines Arylphenols, eines nicht substituierten Naphthols, eines substituierten Naphthols, eines Resorcins, eines alkylsubstituierten Resorcins, eines Pyrogallols, eines alkylsubstituierten Pyrogallols oder einer Mischung dieser Verbindungen mit Formaldehyd, Acetaldehyd, Benzaldehyd oder deren Mischungen, erhalten wurde, oder eine Mischung von 2 oder mehr dieser Harze ist.

**10.** Zusammensetzung nach einem der Ansprüche 1 bis 9, dadurch gekennzeichnet, daß das Phenolharz ein cokondensierter Novolak ist, der durch Kondensation von Formaldehyd mit einer Mischung aus Phenol und p-tert.-Butylphenol mit einem molaren Verhältnis von p-tert.-Butylphenol zu Phenol von 1:10 bis 10:1 erhalten wurde.

**11.** Zusammensetzung nach einem der Ansprüche 1 bis 10, dadurch gekennzeichnet, daß das Phenolharz in einer Menge von ungefähr 30 bis ungefähr 95 Gew.-% vorhanden ist und das Diazochinonderivat in einer Menge von ungefähr 4 bis ungefähr 60 Gew.-% vorhanden ist, jeweils berechnet bezogen auf das Gesamtgewicht der Zusammensetzung.

**12.** Zusammensetzung nach einem der Ansprüche 1 bis 11, dadurch gekennzeichnet, daß das Phenolharz in einer Menge von ungefähr 48 bis ungefähr 90 Gew.-% vorhanden ist und das Diazochinonderivat in einer Menge von ungefähr 8 bis ungefähr 45 Gew.-% vorhanden ist, jeweils berechnet bezogen auf das Gesamtgewicht der Zusammensetzung.

**13.** Zusammensetzung nach einem der Ansprüche 1 bis 12, dadurch gekennzeichnet, daß sie ausserdem einen Farbstoff, der Licht mit einer Wellenlänge von 350 bis 500 nm absorbiert, enthält.

**14.** Zusammensetzung nach einem der Ansprüche 1 bis 13, dadurch gekennzeichnet, daß sie ausserdem ein Lösungsmittel oder eine Lösungsmittelmischung enthält.

**15.** Verfahren zur Herstellung von Negativmustern auf einem Substrat, das die folgenden Schritte umfaßt:

(a) Überziehen des Substrats mit einer Schicht der lichtempfindlichen Zusammensetzung, die mindestens ein Phenolharz und mindestens ein Diazochinonderivat in Form eines Teilesters einer Diazochinonsulfon- oder -carbonsäure und des Phenolharzes umfaßt;

(b) Belichtung dieser Schicht mit ultravioletter Strahlung durch eine Maske, derart, daß nur die gewünschten Teile der Schicht belichtet werden;

(c) Behandlung der so belichteten Schicht mit einer Siliciumverbindung in solcher Weise, daß die Siliciumverbindung selektiv in den bestrahlten Teilen der Schicht absorbiert wird;

(d) Entwicklung der so behandelten Schicht unter Verwendung der Gravurtechniken auf trockenem Wege, derart, daß selektiv die nicht bestrahlten Teile der Schicht entfernt werden, um die Negativmuster zu erhalten, dadurch gekennzeichnet, daß man der lichtempfindlichen Zusammensetzung mindestens eine kondensierte polycyclische aromatische Sulfon- oder Carbonsäure in Form der freien Säure und/oder in Form eines Ammoniumsalzes zufügt, wobei das Kation des Ammoniumsalzes die Formel

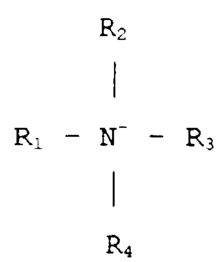

aufweist, in der $R_1$, $R_2$ $R_3$ und $R_4$, die gleich oder verschieden sein können die gleich oder unterschiedlich sein können, jeweils ein Wasserstoffatom oder eine Alkyl- oder Hydroxyalkylgruppe mit 1 bis 4 Kohlenstoffatomen aufweisen, mit der Einschränkung, daß die aromatische Sulfon- oder Carbonsäure keine aromatische Aminosäure und keine Kumarinsäure ist.

**16.** Verfahren nach Anspruch 15, dadurch gekennzeichnet, daß die kondensierte polycyclische aromatische Sulfon- oder Carbonsäure ausgewählt ist aus der Gruppe bestehend aus

1-Naphthalinsulfonsäure,
2-Naphthalinsulfonsäure,
3-Diazo-3,4-dihydro-4-oxo-1-naphthalinsulfonsäure,
6-Diazo-5,6-dihydro-5-oxo-1-naphthalinsulfonsäure,
6-Diazo-5,6-dihydro-5-oxo-2-naphthalinsulfonsäure,
4-Diazo-3,4-dihydro-3-oxo-1-naphthalinsulfonsäure,
5-Diazo-5,6-dihydro-6-oxo-1-naphthalinsulfonsäure,
5-Diazo-5,6-dihydro-6-oxo-2-naphthalinsulfonsäure, den entsprechenden Carbonsäuren und den Mischungen von wenigstens zwei dieser Verbindungen.

**17.** Verfahren nach Anspruch 15, dadurch gekennzeichnet, daß die kondensierte polycyclische aromatische Sulfon- oder Carbonsäure eine Diazochinonsulfonsäure mit der folgenden Formel

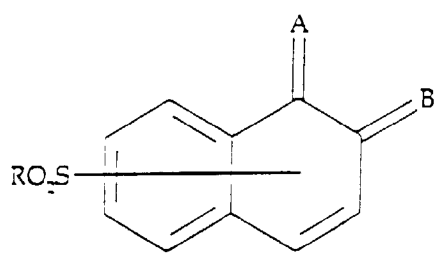

ist, worin A $N_2$ oder O darstellt und B O ist, wenn A $N_2$ ist, oder B $N_2$ ist, wenn A O ist und R OH oder OM ist, wobei M ein Ammonium- oder substituiertes Ammoniumion ist.

**18.** Verfahren nach einem der Ansprüche 15 bis 17, dadurch gekennzeichnet, daß die kondensierte polycyclische aromatische Sulfon- oder Carbonsäure der lichtempfindlichen Zusammensetzung in einer Menge von 0,01 bis ungefähr 24 Gew.-%, berechnet bezogen auf das Gesamtgewicht der Zusammensetzung, zugefügt wird.

**19.** Integrierter Schaltkreis, hergestellt mit einem Verfahren nach einem der Ansprüche 15 bis 18.

**Claims**

**1.** Photosensitive composition comprising at least one phenolic resin, at least one diazoquinone derivative in the form of a partial ester of a diazoquinone-sulphonic or -carboxylic acid and the phenolic resin and at least one condensed polycyclic aromatic sulphonic or carboxylic acid, in the form of the free acid and/or an ammonium salt, the cation of the ammonium salt having the formula :

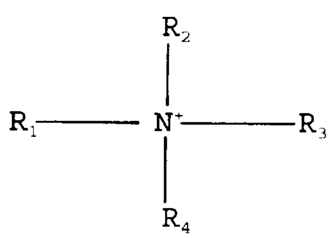

in which $R_1$, $R_2$, $R_3$, and $R_4$, which may be identical or different, each represents a hydrogen atom or an alkyl or

hydroxyalkyl group containing 1 to 4 carbon atoms, with the restriction that the aromatic sulphonic or carboxylic acid is other than an aromatic amino acid and coumarilic acid.

2. Composition according to claim 1, characterized in that the condensed polycyclic aromatic sulphonic or carboxylic acid is selected from the group consisting of

1-naphthalenesulphonic acid,
2-naphthalenesulphonic acid,
2-diazo-3,4-dihydro-4-oxo-1-naphthalenesulphonic acid,
6-diazo-5,6-dihydro-5-oxo-1-naphthalenesulphonic acid,
6-diazo-5,6-dihydro-5-oxo-2-naphthalenesulphonic acid,
4-diazo-3,4-dihydro-3-oxo-1-naphthalenesulphonic acid,
5-diazo-5,6-dihydro-6-oxo-1-naphthalenesulphonic acid,
5-diazo-5,6-dihydro-6-oxo-2-naphthalenesulphonic acid,

the corresponding carboxylic acids and mixtures of at least two of these compounds.

3. Composition according to claim 1, characterized in that the condensed polycyclic aromatic sulphonic or carboxylic acid is a diazoquinonesulphonic acid represented by the formula :

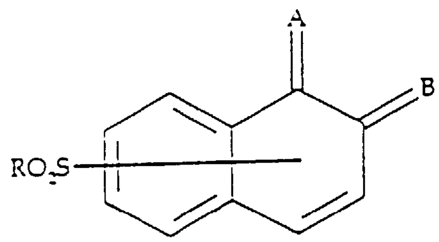

in which A represents $N_2$ or O and B is O when A is $N_2$ or B is $N_2$ when A is O and R represents OH or OM, where M is an ammonium or a substituted ammonium ion.

4. Composition according to any one of claims 1 to 3, characterized in that the condensed polycyclic aromatic sulphonic or carboxylic acid is present in a quantity of approximately 0.01 to approximately 24 % by weight calculated with respect to the total weight of the composition.

5. Composition according to any one of claims 1 to 4, characterized in that the condensed polycyclic aromatic sulphonic or carboxylic acid is present in a quantity of approximately 0.05 to approximately 10 % by weight calculated with respect to the total weight of the composition.

6. Composition according to any one of claims 1 to 5, characterized in that the condensed polycyclic aromatic sulphonic or carboxylic acid is present in a quantity of 0.2 to 2 % by weight calculated with respect to the total weight of the composition.

7. Composition according to any one of claims 1 to 6, characterized in that the condensed polycyclic aromatic sulphonic or carboxylic acid is present in the form of an ammonium salt of which the cation is selected from those represented by the formula

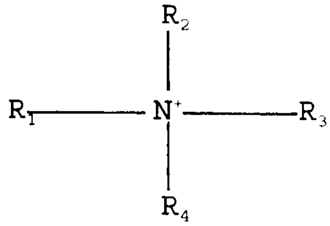

in which $R_1$, $R_2$, $R_3$,and $R_4$, which may be identical or different, each represent a hydrogen atom or an alkyl or hydroxyalkyl group containing 1 to 4 carbon atoms.

**8.** Composition according to any one of claims 1 to 6, characterized in that the condensed polycyclic aromatic sulphonic or carboxylic acid is present in the form of the free acid.

**9.** Composition according to any one of claims 1 to 8, characterized in that the phenolic resin is a poly(vinylphenol), a novolac obtained by condensing a phenol, a mono-di- or trialkylphenol, an arylphenol, a non-substituted naphthol, a substituted naphthol, a resorcinol, an alkyl-substituted resorcinol, a pyrogallol, an alkyl-substituted pyrogallol or a mixture of these compounds with formaldehyde, acetaldehyde, benzaldehyde or mixtures thereof, or a mixture of two or more of these resins.

**10.** Composition according to any one of claims 1 to 9, characterized in that the phenolic resin is a co-condensed novolac obtained by condensing formaldehyde with a mixture of phenol and p-tert-butylphenol in which the molar ratio of p-tert-butylphenol to phenol is from 1:10 to 10:1.

**11.** Composition according to any one of claims 1 to 10, characterized in that the phenolic resin is present in a quantity of approximately 30 to approximately 95 % by weight and the diazoquinone derivative is present in a quantity of approximately 4 to approximately 60 % by weight calculated with respect to the total weight of the composition.

**12.** Composition according to any one of claims 1 to 11, characterized in that the phenolic resin is present in a quantity of approximately 48 to approximately 90 % by weight and the diazoquinone derivative is present in a quantity of approximately 8 to approximately 45 % by weight calculated with respect to the total weight of the composition.

**13.** Composition according to any one of claims 1 to 12, characterized in that it additionally contains a dye absorbing light at a wave length of 350 to 500 nm.

**14.** Composition according to any one of claims 1 to 13, characterized in that it additionally contains a solvent or a mixture of solvents.

**15.** Process for forming negative patterns on a substrate comprising the following steps :

(a) covering the substrate with a layer of photosensitive composition which comprises at least one phenolic resin and at least one diazoquinone derivative in the form of a partial ester of a diazoquinone-sulphonic or -carboxylic acid and the phenolic resin.

(b) exposing this layer to ultraviolet radiation through a mask so that only the desired parts of the layer are exposed;

(c) treating the layer thus exposed by a silicon compound, so that the said silicon compound is selectively absorbed in the irradiated parts of the layer;

(d) developing the layer thus treated using dry gravure techniques so as to remove selectively the non-irradiated parts of the layer to obtain negative patterns, characterized in that there is added to the photosensitive composition at least one condensed polycyclic aromatic sulphonic or carboxylic acid, in the form of the free acid and/or an ammonium salt, the cation of the ammonium salt having the formula :

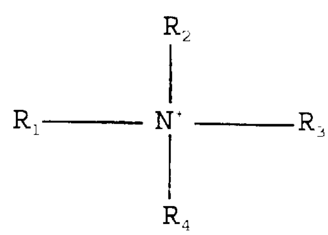

in which $R_1$, $R_2$, $R_3$, and $R_4$, which may be identical or different, each represent a hydrogen atom or an alkyl

or hydroxyalkyl group containing 1 to 4 carbon atoms, with the restriction that the aromatic sulphonic or carboxylic acid is other than an aromatic amino acid and coumarilic acid.

**16.** Process according to claim 15, characterized in that the condensed polycyclic aromatic sulphonic or carboxylic acid is selected from the group consisting of

1-naphthalenesulphonic acid,
2-naphthalenesulphonic acid,
3-diazo-3,4-dihydro-4-oxo-1-naphthalenesulphonic acid,
6-diazo-5,6-dihydro-5-oxo-1-naphthalenesulphonic acid,
6-diazo-5,6-dihydro-5-oxo-2-naphthalenesulphonic acid,
4-diazo-3,4-dihydro-3-oxo-1-naphthalenesulphonic acid,
5-diazo-5,6-dihydro-6-oxo-1-naphthalenesulphonic acid,
5-diazo-5,6-dihydro-6-oxo-2-naphthalenesulphonic acid,

the corresponding carboxylic acids and mixtures of at least two of these compounds.

**17.** Process according to claim 15, characterized in that the condensed polycyclic aromatic sulphonic or carboxylic acid is a diazoquinonesulphonic acid represented by the following formula :

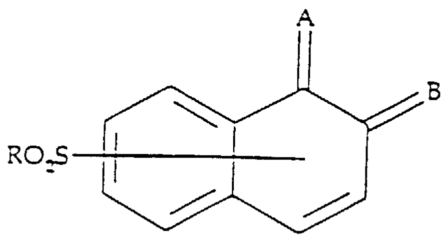

in which A represents $N_2$ or O and B is O when A is $N_2$ or B is $N_2$ when A is O and R represents OH or OM, where M is an ammonium or a substituted ammonium ion.

**18.** Process according to any one of claims 15 to 17, characterized in that the condensed polycyclic aromatic sulphonic or carboxylic acid is added to the photosensitive composition in a quantity of 0.01 to approximately 24 % by weight calculated with respect to the total weight of the composition.

**19.** Integrated circuit manufactured by means of the process according to any one of claims 15 to 18.